# EUROPEAN PATENT APPLICATION

(11) **EP 1 737 287 A2**
(43) Date of publication of application: **27.12.2006**
(21) Application number: 06253181.9
(22) Date of filing: 20.06.2006
(51) Int. Cl.: H05K 9/00

(54) **Electronic device**

(30) Priority: 22.06.2005 JP 2005182188
(71) Applicant: ORION ELECTRIC CO., Ltd., Takefu-City, Fukui 915-8555 (JP)
(72) Inventor: Tokuda, Takashi c/o Intell. Pty Dept., Echizen-city Fukui 915-8555 (JP)
(74) Representative: Paget, Hugh Charles Edward

(57) **Abstract**

The invention provides a shield case capable of selecting a mounting method among multiple methods. A shield case 3 for housing an HDMI board 5 is composed of a frame member 6 having two opening portions of the same design, and cover members 7 and 8 attached in removable manner to the opposing opening portions of the frame member 6, wherein the HDMI board 5 and the frame member 6 can be turned up-side down to change the arrangement order of audio input terminal (right) 5b and audio input terminal (left) 5c disposed on the HDMI board 5 from left to right and right to left. Further, by forming an opening portion 6b on the frame member 6 and disposing a connector 5d to be exposed therethrough, the shield case 3 can be disposed perpendicularly. In other words, the present shield case can be disposed in three different ways by a single structure.

## Description

### BACKGROUND OF THE INVENTION

### Field of the Invention

The present invention relates to an electronic device having an electronic component covered with a shield case and capable of being mounted via multiple ways on a circuit board.

### Description of the Related Art

Heretofore, in the field of electronic devices, there have been disclosed methods for covering a circuit board having specific functions with a shield case in order to reduce the influence of electromagnetic waves generated from various components.

For example, Japanese Patent Application Laid-Open Publication No. 08-148875 (patent document 1) discloses a shield case composed of a frame member surrounding the circumference of a first circuit board and a cover member attached to the frame member for covering the opening portion of the frame member, wherein a first connector being electrically connected to the first circuit board is exposed through an opening portion formed to the frame member, and a second connector constituting a pair with the first connector is fit and fixed to a second circuit board within the electronic device, by which the first circuit board and the second circuit board are connected electrically, and at the same time, the first circuit board or shield case is fixed to the second circuit board.

Furthermore, Japanese Patent Application Laid-Open Publication No. 2005-108881 (patent document 2) similarly discloses a shield case having a frame member with a supporting member for supporting the circuit board and having a circuit board attached thereto, wherein an opening portion of the frame member is covered with a cover member.

However, according to the above-mentioned shield cases, the design and mounting methods of the shield cases had to be determined considering the exterior appearance of the electronic device, the inner structure thereof, the pattern on the board and so on, so it was difficult for the shield case to be designed as a common component that can be used in various electronic devices.

### SUMMARY OF THE INVENTION

In consideration of the above-mentioned problems, the present invention is aimed at providing an electronic device capable of being used as a common component for various electronic devices and also capable of being mounted via multiple ways.

An electronic device according to a first aspect comprises an electronic component covered with a shield case and a circuit board on which the electronic component is mounted, wherein the shield case comprises a frame member having opening portions formed on two opposing sides, and a pair of cover members removably fit to the frame member to cover the opening portions, wherein when the shield case is mounted horizontally with respect to the circuit board, the cover members are composed of a first cover member having a mounting leg for fixing the electronic component horizontally and covering a lower side of the frame member, with the frame member capable of being turned up-side down and fit thereto, and a substantially planar second cover member opposed to the first cover member and covering an upper side of the frame member, whereas when the electronic component is mounted perpendicularly with respect to the circuit board, both sides of the frame member are covered with the second cover member, according to which the electronic component can be mounted both horizontally and perpendicularly with respect to the circuit board, and be turned up-side down when mounted horizontally.

According to the arrangement of the first aspect, the shield case has the side of the frame member facing the circuit board (hereinafter called the lower side) covered with a first cover member having a leg portion, and the opposing side from the cover member with the leg portion covered with a planar second cover member, so that by fixing the leg portion to the circuit board or the chassis of an electronic device and the like, the shield case can be mounted horizontally with respect to the circuit board. Further, the frame member can be turned up-side down and fit in removable manner to the first cover member. Moreover, it is possible to have both opening portions covered with the second cover member which is planar so as to form a substantially rectangular shield case that can be mounted perpendicularly with respect to the circuit board. In other words, the shield case mounted on the electronic device can be mounted both horizontally and perpendicularly, and it can also be turned up-side down when mounted horizontally.

The electronic device according to a second aspect relates to the electronic device according to the aspect 1, characterized in that the electronic component is formed by housing an input and/or output circuit board in the shield case, the input and/or output circuit board having an exterior connecting terminal electrically connected thereto and protruded toward the exterior from the shield case, wherein the electronic component can be disposed horizontally, perpendicularly and turned up-side down when mounted horizontally with respect to the circuit board so that the exterior derived position of the external connecting terminal can be selectively varied.

According to the arrangement of the second aspect, the exterior derived position of the external connecting terminal protruded from the shield case can be varied by mounting the shield case horizontally or perpendicularly with respect to the circuit board, and when the shield case is mounted horizontally, the shield case can be turned up-side down. In other words, the layout of the external connecting terminal can be selected from three variations.

The electronic device according to a third aspect relates to the electronic device according to the aspect 2, characterized in that when the electronic component is mounted horizontally with respect to the circuit board, the circuit board is equipped with a first connector, and the input and/or output circuit board is equipped with a second connector with a cable, so that the input and/or output circuit board and the circuit board are connected electrically via the first and second connectors.

According to the arrangement of the third aspect, when the shield case and the input and/or output circuit board housed in the shield case are to be mounted horizontally with respect to the circuit board, a first connector is connected to the circuit board and a second connector with a cable corresponding to the first connector is connected to the input and/or output circuit board, so that by engaging the connectors, the input and/or output circuit board and the circuit board can be connected electrically.

The electronic device according to a fourth aspect relates to the electronic device according to the aspect 2, characterized in that when the electronic component is mounted perpendicularly with respect to the circuit board, the circuit board is equipped with a first connector, and the input and/or output circuit board is equipped with a second connector exposed through an opening formed to the lower side of the frame member, so that the input and/or output circuit board and the circuit board are connected electrically via the first and second connectors.

According to the arrangement of the fourth aspect, when the shield case and the input and/or output circuit board housed in the shield case are mounted perpendicularly with respect to the circuit board, a first connector is connected the circuit board and a second connector is connected to the input and/or output circuit board and exposed through an opening formed to the lower side of the frame member constituting the shield case, so that by engaging the connectors, the input and/or output circuit board and the circuit board can be connected electrically.

### BRIEF DESCRIPTION OF THE DRAWINGS

FIG. 1 is a partially enlarged perspective view showing an electronic device according to embodiment 1 seen from the rear side.
FIG. 2 is an exploded perspective view showing a shield case according to the same.
FIG. 3 is a perspective view showing an HDMI board housed in the shield case according to the same.
FIG. 4 is a perspective view showing a frame member constituting the shield case according to the same.
FIG. 5 is a perspective view showing a cover member constituting the shield case according to the same.
FIG. 6 is a perspective view showing a cover member with a leg portion constituting the shield case according to the same.
FIG. 7 is a perspective view showing the state in which a connector with a cable is connected to the HDMI board according to the same.
FIG. 8 is a perspective view showing the shape of connectors of the HDMI board according to the same.
FIG. 9 is an explanatory view showing the state prior to and after turning the frame for fixing the HDMI board up-side down according to the same.
FIG. 10 is a perspective view showing the state prior to mounting the shield case to the circuit board according to the same.
FIG. 11 is a perspective view showing the state after mounting the shield case to the circuit board according to the same.

### DETAILED DESCRIPTION OF THE PREFERRED EMBODIMENTS

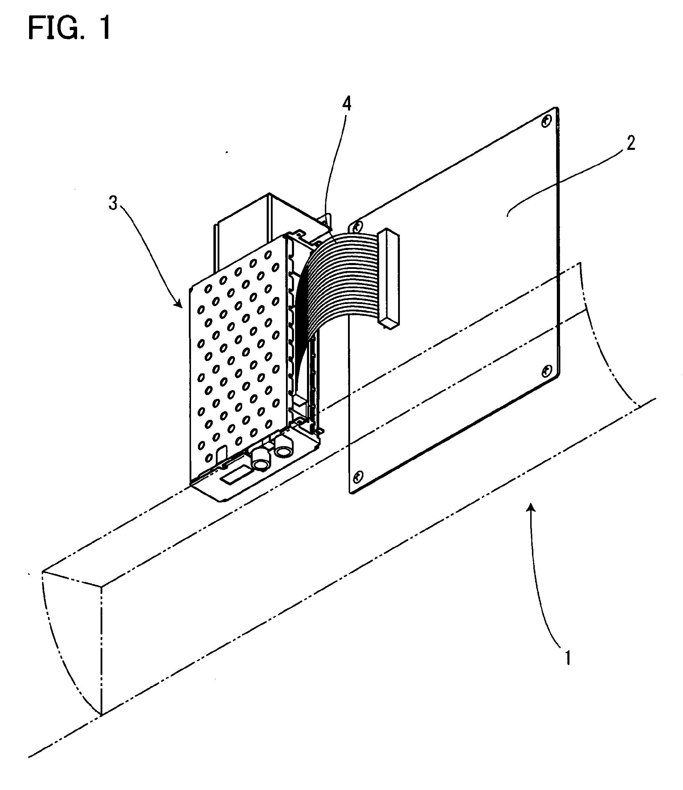

The preferred embodiments for carrying out the present invention will now be described with reference to FIGS. 1 through 10. Of course, the present invention is applicable to examples other than those described in the present embodiments within the scope of the invention.

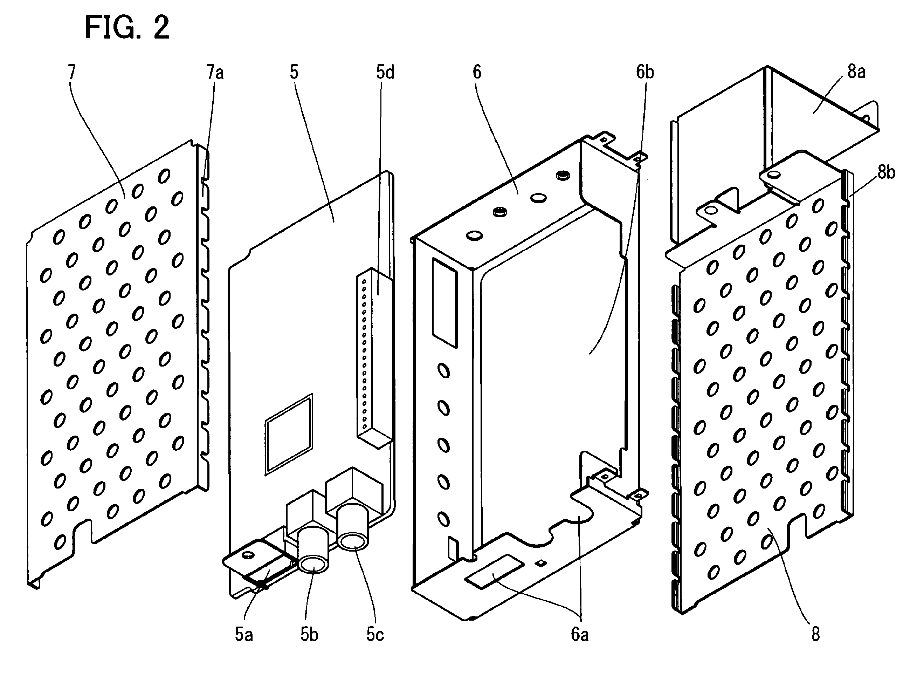

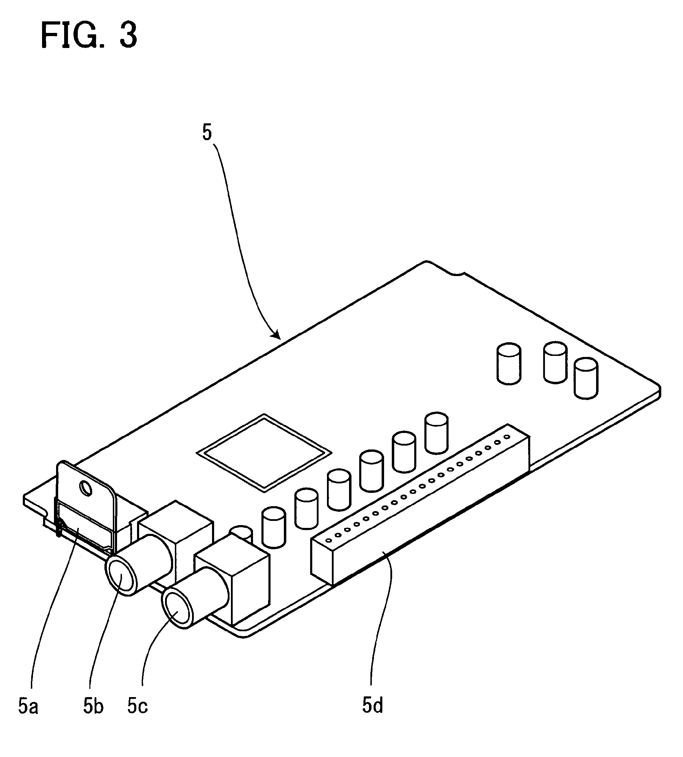

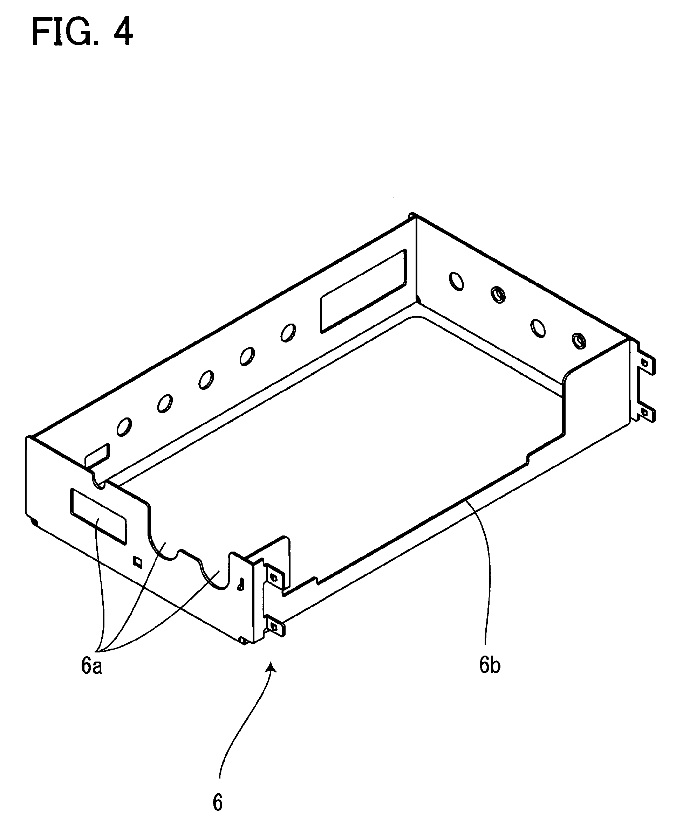

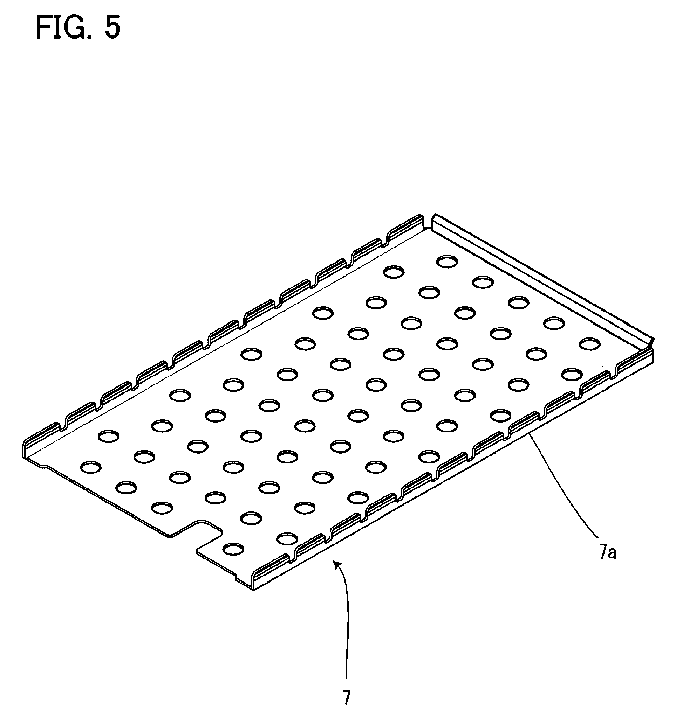

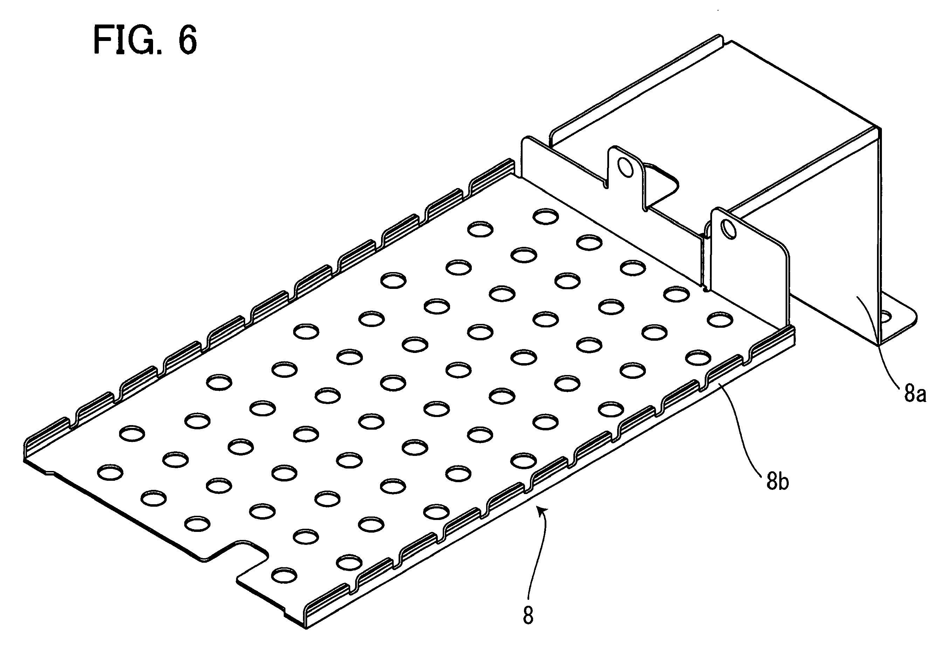

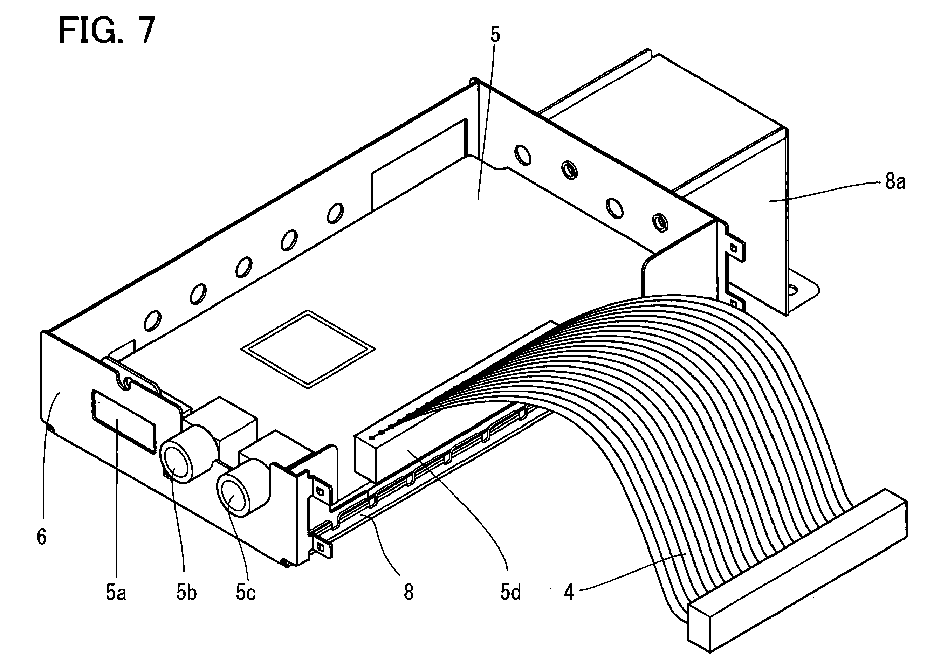

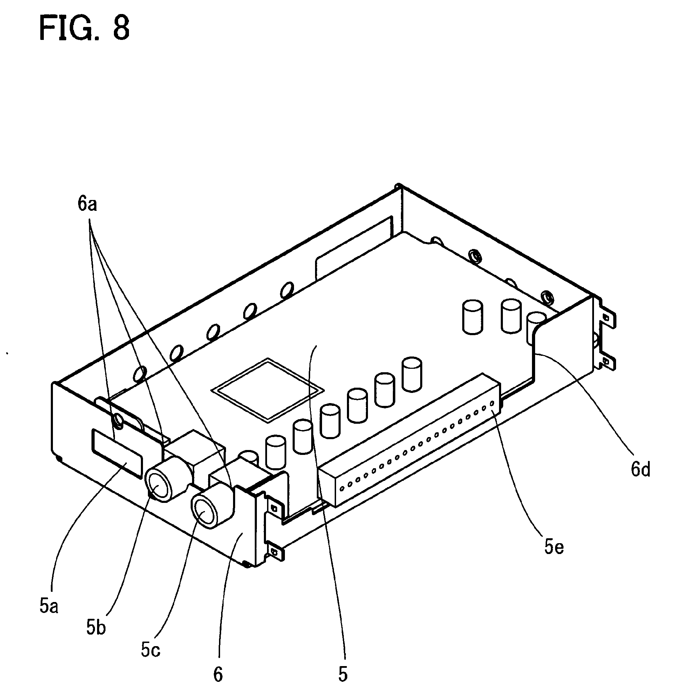

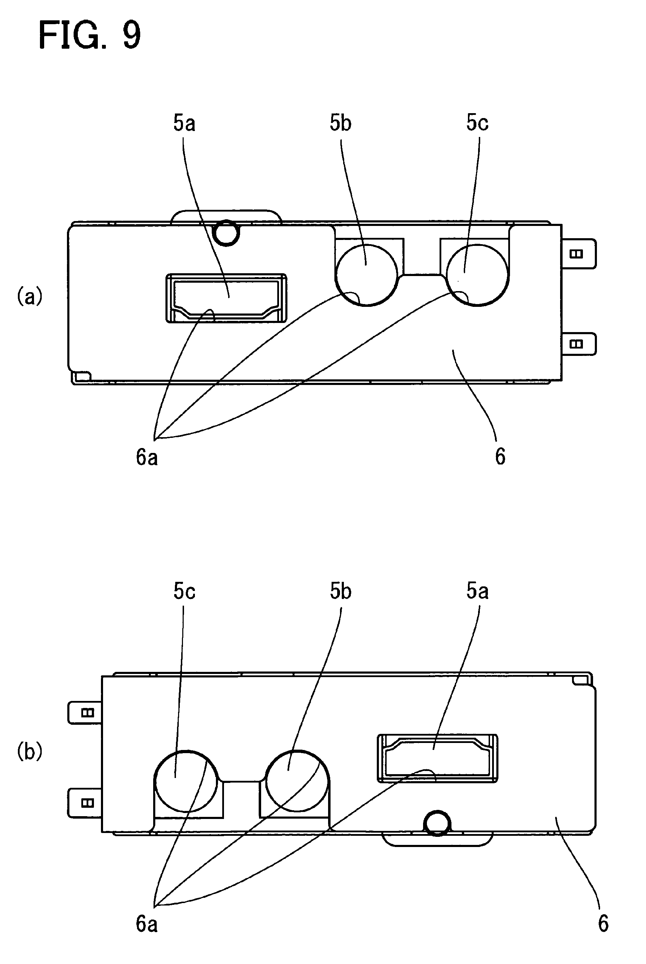

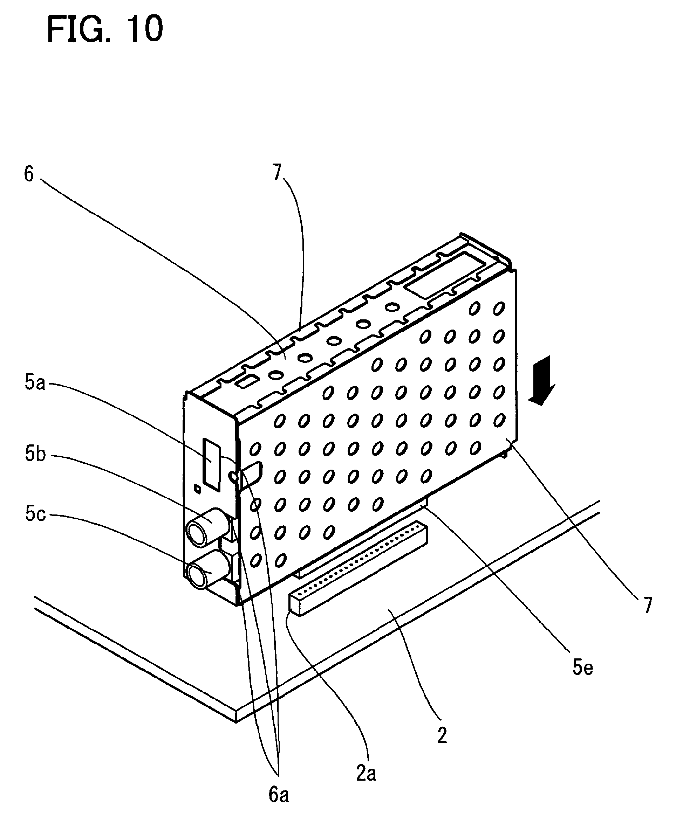

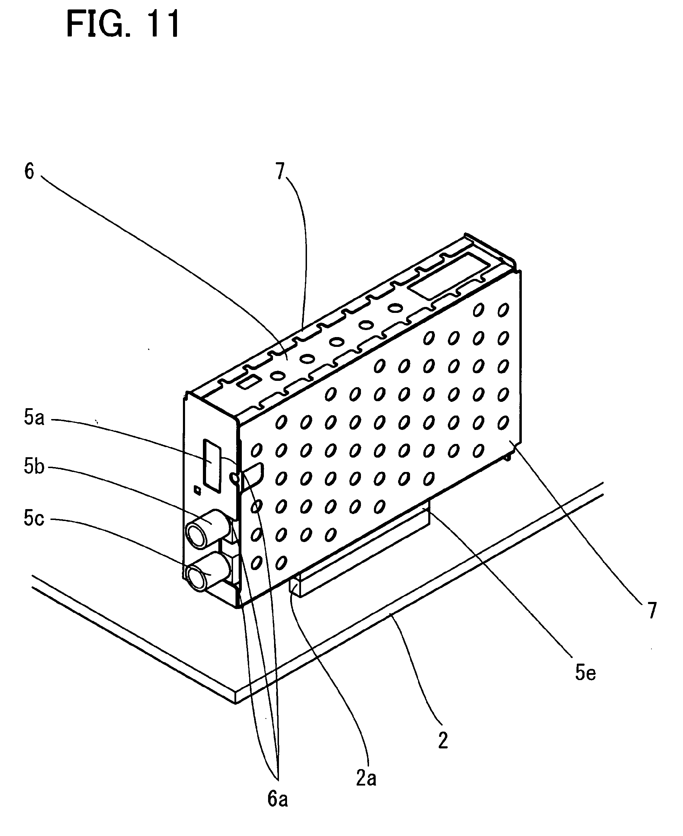

FIGS. 1 through 11 illustrate the preferred embodiments of the present invention, wherein FIG. 1 is a perspective view showing an electronic device according to the present embodiment. FIG. 2 is a perspective view showing the shield case provided to the electronic device, FIG. 3 is a perspective view showing an HDMI (high-definition multimedia interface) board which is an example of an input and/or output circuit board being the electronic component housed in the shield case, FIG. 4 is a perspective view showing a frame member surrounding the HDMI board, and FIG. 5 is a perspective view showing a cover member for covering the opposing opening portions of the frame member. FIG. 6 is a perspective view showing a cover member with a mounting leg portion. FIG. 7 is a perspective view showing the state in which a connector with a cable is connected to the HDMI board being fixed to the frame member. FIG. 8 is a perspective view showing the state in which a connector is connected for disposing the shield case perpendicularly on the HDMI board fixed to the frame member. FIG. 9 is a front view of the frame member, wherein FIG. 9 (a) shows a state prior to turning the frame member up-side down, and FIG. 9 (b) shows a state after the frame member is turned up-side down. FIG. 10 is a perspective view showing the state prior to disposing the shield case perpendicularly with respect to the circuit board, and FIG. 11 is a perspective view showing the state in which the shield case is disposed perpendicularly with respect to the circuit board.

The structure of the electronic device according to the present embodiment will be described with reference to FIG. 1. FIG. 1 is a partially enlarged perspective view showing the rear side of the electronic device. Reference number 1 denotes an electronic device having an external connecting terminal on the rear side thereof, and reference number 2 denotes a circuit board disposed within the electronic device 1. Reference number 3 denotes a shield case, and reference number 4 denotes a connector with a cable which is a second connector for electrically connecting the circuit board 2 and an HDMI board described later housed in the shield case 3.

Now, the structure of the shield case 3 will be described with reference to FIGS. 2 through 6. FIG. 2 is an exploded perspective view showing the shield case 3. Reference number 5 denotes an HDMI board which is an example of an input and/or output circuit board being the electronic component housed in the shield case 3. Reference number 6 denotes a frame member which is one of the components constituting the shield case 3, reference number 7 denotes a cover member which is a second cover member covering one of the opposing openings of the frame member 6, and reference number 8 denotes a cover member with a leg portion which is a first cover member covering the other opening portion of the frame member 6. The cover member 7 and the cover member with a leg portion 8 are elastically fit to the frame member 6 via claws respectively provided thereto. FIG. 3 is a perspective view showing the HDMI board 5. The HDMI board 5 includes an HDMI interface terminal 5a for inputting digital video/audio signals, an audio input terminal (right) 5b, an audio input terminal (left) 5c, and a connector 5d used for electrical connection with the circuit board 2. FIG. 4 is a perspective view showing the frame member 6. Reference number 6a denotes opening portions for allowing the HDMI interface 5a, the audio input terminal (right) 5b and the audio input terminal (left) 5c to be exposed to the exterior from within the frame member 6, respectively, and 6b denotes an opening portion for allowing the connector 5d to be exposed to the exterior. FIG. 5 is a perspective view showing the cover member 7, and FIG. 6 is a perspective view showing the cover member with a leg portion 8. Both cover members are formed so that they can be removably attached to both of the two openings formed to the frame member 6. Moreover, reference number 8a denotes a leg portion for mounting the shield case 3. FIG. 7 is a perspective view showing how a connector with a cable 4 is attached to the shield case 3, showing the state in which the cover member 7 is removed.

As described, the shield case 3 according to the present embodiment is composed of the HDMI board 5, the frame member 6 surrounding the outer circumference thereof, the cover member 7 and the cover member with a leg portion 8 that cover the opposing openings of the frame member 6, wherein the HDMI board 5 is fixed via fixing means such as screws not shown to the frame member 6, with the HDMI interface 5a, the audio input terminal (right) 5b and the audio input terminal (left) 5c provided on the HDMI board 5 exposed to the exterior through opening portions 6a formed to one side of the frame member 6. Moreover, the cover member with a leg portion 8 has a leg portion 8a, which is fixed to the circuit board 2 or a chassis of the electronic device 1. Though the shield case 3 and the circuit board 2 are spaced apart, the HDMI board 5 housed in the shield case 3 can be electrically connected to the circuit board 2 by having a connector with a cable 4 attached to a connector 5d disposed on the HDMI board 5 through the opening portion 6a. In other words, since the leg portion 8a allows the shield case 3 to be mounted without being in direct contact with the circuit board 2, it is not necessary to create a space on the circuit board 2 for mounting the shield case 3, and since the area in which the shield case 3 contacts the circuit board 2 is limited, the restriction on the circuit pattern layout of the circuit board 2 can be reduced.

Moreover, in various electronic devices, there are cases in which the audio input terminal (right) 5b and the audio input terminal (left) 5c should preferably be disposed with the left and the right sides arranged oppositely from the state shown in FIG. 2. For example, on the rear side of the electronic device such as a television receiver with a speaker, if audio input terminals are to be arranged as shown in FIG. 9(a), it is appropriate that the audio input terminal (right) 5b is disposed on the left side seen from the rear side of the electronic device and the audio input terminal (left) 5c is disposed on the right side in correspondence to the position of speakers provided in the electronic device, but if the HDMI board 5 is disposed on the front side of the electronic device in the order shown in FIG. 9(a), the arrangements of the speakers and the audio input terminals will be inconsistent. At this time, since the two cover members 7 and 8 can each be reversed and attached in a removable manner on both opposing opening portions of the frame member 6, the arrangement order of the audio input terminal (right) 5b and the audio input terminal (left) 5c can be reversed as shown in FIG. 9 (b) by turning the frame body 6 up-side down. In other words, by selectively changing the upper and lower sides of the frame 6 with respect to the cover member with a leg portion 8, the positions of the audio input terminal (right) 5b and the audio input terminal (left) 5c can be varied easily without preparing new components.

Moreover, in addition to disposing the shield case 3 in parallel with the circuit board 2, it is possible to dispose the shield case 3 perpendicularly with respect to the circuit board 2. In that case, as shown in FIGS. 8, 10 and 11, the connector 5e is arranged on the HDMI board 5 so that it is exposed to the exterior through the opening portion 6b of the frame member 6. Furthermore, if the shield case 3 is disposed in parallel with respect to the circuit board 2, one of the cover members for covering the opposing opening portions of the frame member 6 is the cover member with a leg portion 8, but if the shield case 3 is disposed perpendicularly, the leg portion will not be necessary, so two cover members 7 without leg portions are used to cover the openings. Next, as shown in FIG. 10, by arranging a connector 2a corresponding to the connector 5e on the circuit board 2 and engaging the connector 5e disposed on the shield case 3 to the connector 2a disposed on the circuit board 2, as shown in FIG. 11, the shield case 3 can be mounted perpendicularly on the circuit board. As described, the HDMI board 5 housed in the shield case 3 and the circuit board 2 can be connected electrically, and the shield case 3 can be fixed by engaging the connector 5e to the connector 2a. According to the structure of the present embodiment, the shield case 3 can be mounted in three different ways in total, two ways in parallel with respect to the circuit board 2 and one way in the perpendicular direction, by changing the cover member, so the arrangement of terminals can be varied flexibly. In other words, in the manufacture of electronic devices requiring identical connecting terminals to be disposed in multiple locations, the shield case can be used in common in all the locations, according to which the manufacturing costs can be cut down.

The preferred embodiments of the present invention have been described in detail up to now, but the present invention is not restricted to these embodiments, and various modifications are possible within the scope of the present invention. For example, the electronic component according to the present embodiment is an HDMI board, but the present invention is not restricted thereto, and can be applied to circuit boards having other input terminals or output terminals, or both the input and output terminals.

The effects of the present invention are as follows.

According to the first aspect, the electronic device comprises an electronic component covered with a shield case and a circuit board on which the electronic component is mounted, wherein the shield case comprises a frame member having opening portions formed on two opposing sides, and a pair of cover members removably fit to the frame member to cover the opening portions, wherein when the shield case is mounted horizontally with respect to the circuit board, the cover members are composed of a first cover member having a mounting leg for fixing the electronic component horizontally and covering a lower side of the frame member, with the frame member capable of being turned up-side down and fit thereto, and a substantially planar second cover member opposed to the first cover member and covering an upper side of the frame member, whereas when the electronic component is mounted perpendicularly with respect to the circuit board, both sides of the frame member are covered with the second cover member, according to which the electronic component can be mounted both horizontally and perpendicularly with respect to the circuit board, and be turned up-side down when mounted horizontally; accordingly, the electronic component covered with the shield case can be mounted via three different ways, and the layout of electronic components can be varied, so that the components of a shield case having a single design can be used to correspond to various uses in which the mounting methods of the electronic components vary, and there is no need to form a new dedicated shield case for each use, so the production costs of the electronic device can be cut down.

According to the second aspect, the electronic device according to the aspect 1 further characterizes in that the electronic component is formed by housing an input and/or output circuit board in the shield case, the input and/or output circuit board having an exterior connecting terminal electrically connected thereto and protruded toward the exterior from the shield case, wherein the electronic component can be disposed horizontally, perpendicularly and turned up-side down when mounted horizontally with respect to the circuit board so that the exterior derived position of the external connecting terminal can be selectively varied; accordingly, the arrangement of the external connecting terminals of the input and/or output circuit board can be selected from three different ways, two ways in the horizontal direction and one way in the perpendicular direction.

According to the third aspect, the electronic device according to the aspect 2 further characterizes in that when the electronic component is mounted horizontally with respect to the circuit board, the circuit board is equipped with a first connector, and the input and/or output circuit board is equipped with a second connector with a cable, so that the input and/or output circuit board and the circuit board are connected electrically via the first and second connectors; accordingly, when the shield case is mounted horizontally with respect to the circuit board, the first cover member with a leg portion prevents the shield case from lifting up from the circuit board and interfering with electronic components mounted on the circuit board, and even though there is a distance formed between the circuit board and the input and/or output circuit board disposed within the shield case, the use of the second connector with a cable enables the circuit board and the input and/or output circuit board to be easily connected electrically.

According to the fourth aspect, the electronic device according to the aspect 2 further characterizes in that when the electronic component is mounted perpendicularly with respect to the circuit board, the circuit board is equipped with a first connector, and the input and/or output circuit board is equipped with a second connector exposed through an opening formed to the lower side of the frame member, so that the input and/or output circuit board and the circuit board are connected electrically via the first and second connectors; accordingly, when the shield case is mounted perpendicularly, the shield case can be fixed to the circuit board by simply engaging the first connector and the second connector, and at the same time, the input and/or output circuit board within the shield case and the circuit board can be connected electrically.

## Claims

1. An electronic device comprising an electronic component covered with a shield case and a circuit board on which the electronic component is mounted, wherein the shield case comprises a frame member having opening portions formed on two opposing sides, and a pair of cover members removably fit to the frame member to cover the opening portions, wherein when the shield case is mounted horizontally with respect to the circuit board, the cover members are composed of a first cover member having a mounting leg for fixing the electronic component horizontally and covering a lower side of the frame member, with the frame member capable of being turned up-side down and fit thereto, and a substantially planar second cover member opposed to the first cover member and covering an upper side of the frame member, whereas when the electronic component is mounted perpendicularly with respect to the circuit board, both sides of the frame member are covered with the second cover member, according to which the electronic component can be mounted both horizontally and perpendicularly with respect to the circuit board, and be turned up-side down when mounted horizontally.

2. The electronic device according to claim 1, wherein the electronic component is formed by housing an input and/or output circuit board in the shield case, the input and/or output circuit board having an exterior connecting terminal electrically connected thereto and protruded toward the exterior from the shield case, wherein the electronic component can be disposed horizontally, perpendicularly and turned up-side down when mounted horizontally with respect to the circuit board so that the exterior derived position of the external connecting terminal can be selectively varied.

3. The electronic device according to claim 2, wherein when the electronic component is mounted horizontally with respect to the circuit board, the circuit board is equipped with a first connector, and the input and/or output circuit board is equipped with a second connector with a cable, so that the input and/or output circuit board and the circuit board are connected electrically via the first and second connectors.

4. The electronic device according to claim 2, wherein when the electronic component is mounted perpendicularly with respect to the circuit board, the circuit board is equipped with a first connector, and the input and/or output circuit board is equipped with a second connector exposed through an opening formed to the lower side of the frame member, so that the input and/or output circuit board and the circuit board are connected electrically via the first and second connectors.
